(19) Europäisches Patentamt
European Patent Office
Office européen des brevets

(11) EP 2 352 039 A1

(12) EUROPEAN PATENT APPLICATION
published in accordance with Art. 153(4) EPC

(43) Date of publication:
03.08.2011 Bulletin 2011/31

(51) Int Cl.:
*G01T 1/24* (2006.01)     *H01L 39/22* (2006.01)
*H01L 27/18* (2006.01)     *G06N 99/00* (2010.01)

(21) Application number: 09820297.1

(22) Date of filing: 09.10.2009

(86) International application number:
PCT/ES2009/070428

(87) International publication number:
WO 2010/043742 (22.04.2010 Gazette 2010/16)

(84) Designated Contracting States:
AT BE BG CH CY CZ DE DK EE ES FI FR GB GR
HR HU IE IS IT LI LT LU LV MC MK MT NL NO PL
PT RO SE SI SK SM TR

(30) Priority: 17.10.2008 ES 200802933

(71) Applicants:
• Consejo Superior de Investigaciones Cientificas
(CSIC)
28006 Madrid (ES)
• Universidad del Pais Vasco
48940 Leioa Vizcaya (ES)

• Universidad De Santiago De Chile
CP 9170022, Estación Central Santiago (CL)

(72) Inventors:
• GARCÍA RIPOLL, Juan José
E-28006 Madrid (ES)
• SOLANO, Enrique
E-48940 Leioa (Vizcaya) (ES)
• ROMERO, Guillermo
Santiago de Chile (CL)

(74) Representative: Pons Ariño, Maria Purificación
Gl. Rubén Darío 4
E-28010 Madrid (ES)

(54) **PHOTON DETECTOR IN THE MICROWAVE RANGE AND DETECTION METHOD**

(57)     Design of a device for detecting and counting photons based on a one-dimensional waveguide (1) connected to a number of bistable absorbent elements (2) that perform the detection, said device being used to detect and classify microwave radiation (3). Said detection is performed using qubits, the states of which are irreversibly changed by the passage of the absorbed photons originating in the induced radiation.

FIG. 1a

## Description

## OBJECT OF THE INVENTION

The main object of the present invention is the design of a photon detection and counting device based on a unidimensional waveguide coupled to a number of bi-stable absorbent elements that carry out the detection, applied to the detection and characterisation of microwaves.

Another object of the invention is a microwave photon detection and quantification method using the aforementioned elements.

## BACKGROUND OF THE INVENTION

The field of quantum circuits and their possible applications has undergone significant development in recent years. A quantum circuit is basically an element formed by, among other things, superconducting elements working in the quantum degenerated regime. These types of elements are currently known as Josephson junctions, SQUIDs, islands of Cooper pairs, waveguides and cavities, all cooled at very low temperatures (20mK) and working in the quantum degenerated regime.

Among the numerous applications of these circuits, we must point out the creation of artificial atoms: circuits with discreet energy levels and quantised loading, flow or phase degrees. These elemental circuits are used to store quantum bits (qubits) for quantum information processing. Among the multiple variants we find loading qubits, flow qubits and phase qubits.

A more recent but very relevant second application is the manipulation of microwave radiation under the quantum regime, where the quanta of energy that compose the electromagnetic field are resolved. Among the most relevant experiments, the exchange of microwave photons between stationary fields of resonant cavities and superconducting qubits, on-demand photon generation and the non-linear effects that arise on disposing qubits in resonators and transmission lines are worth highlighting. All of these applications stem from integrating the fields of quantum optics and mesoscopic physics.

At present, both in the case of applications of quantum information and microwave technology, one of the major obstacles is the current non-existence of photon detectors in the range of 1-100 GHZ.

The main difficulties of building such a device are the following:

- Cryogenic linear amplifiers cannot distinguish between individual photons or the number of photons in a very weak signal.
- The effective cross-section of the interaction between microwave fields and material elements or even qubits is small.
- The use of cavities to increase radiation-matter coupling introduces new difficulties, such as reaching a commitment between high resonator quality (and therefore adequate coupling) and reflectivity of the resonator mirrors (which hampers the entrance of photons).
- Given that the objective is to study microwave signals with a small number of photons and therefore in the quantum regime, it is not possible to perform continuous measurements without altering the signal. In order to avoid continuous metering, a synchronisation mechanism between the arrival of the signal and the activation of the detector, which is equally difficult, is required.

At present, there are numerous experimental and theoretical groups working on the microwave photon detection problem.

The efforts are focused on proposals that approach the qubit-photon system in a coherent manner, using dispersive non-linear effects or branch-type effects that would amplify the incoming signal.

However, to date there is no experimental or theoretical embodiment in patent literature that solves all the previously identified problems.

Given that coherent systems based on control or non-linear effects have not borne fruit, incoherent and irreversible processes are proposed, where the photons give rise to mesoscopic changes in the circuit and can be detected at a later stage. Current experiments with superconducting circuits seek applications in quantum processing of information and incoherent effects are considered harmful. An important exception is the field of bolometry, where there are applications of metastable superconducting circuits for measuring temperatures in a very accurate manner.

## DESCRIPTION OF THE INVENTION

The objective of the invention is to develop a detection device that will carry out said function in a manner similar to the photodetectors used in the visible optical range; this implies the individual detection of photons and gives rise to irreversible processes or changes in the state of the material that can be easily and accurately detected. The microwave photon detection and counting device is composed of a unidimensional waveguide which transmits microwave radiation along the interior of a set of absorbent elements in charge of capturing the photons. Said absorbent elements are bistable quantum circuits similar to the qubits used in quantum information.

A qubit is the counterpart in quantum computing to the binary digit; but in this case, that of quantum computing, a qubit as a unit of information is capable of representing 0 or 1, or both 0 and 1. Said elements, which are initially in a metastable state |0>, can carry out an irreversible transition to a stable state |g> once a photon has been absorbed during the passage of microwave radiation; this irreversible process consists of the measurement sought by the designed device. As this induced change is irreversible and given that the final state of the bistable elements can be verified at a later stage, any backward movement effect induced by continuous metering is avoided; due to which the difficulty in the device design is that of finding an arrangement and properties of said elements that will provide the greatest possible efficiency in photon absorption.

In order to achieve said photon absorption efficiency, the microwave photon detection and counting device is composed of a waveguide that will be in charge of transporting the photons, for which a coaxial guide inserted between two earthed conductor planes is used.

Said conductor planes are separated from each other by a distance much smaller than the wavelength $\lambda$ of the transmitted radiation; the electromagnetic field is propagated by load density waves approximately unidimensional in shape. The waveguide (1) has a dispersion relation of w (k) which relates photon frequency with its wavelength and momentum $\lambda = \dfrac{2\pi}{k}$. The detector uses a main frequency $\omega_0$; this relation can be approximated with a straight line $\omega \cong v_g k (\omega_k \cong \omega_0)$ the slope of which is the microwave group speed. We will assume that the conducting material is at a very low temperature and that the losses and distortions are irrelevant for this and other reasons.

The second element is constituted by the absorbent elements or qubits responsible for the detection. These shall be circuits much smaller in size than the microwave radiation wavelength and can therefore be treated as specific elements. Each circuit works in the quantum regime at a temperature sufficiently low to consider only two energy levels.

The first is |0>, a metastable state wherein all the qubits are prepared before performing the detection. It is a state with a much longer average life than the detection process, separated from the excited level |1> by energy $\hbar\omega \cong \hbar\omega 0$. This last level has a much shorter average life and declines at a speed $\Gamma << \omega$ to another level |g> macroscopically distinguishable from the rest.

Operation of the detector is as follows: firstly, all the qubits are prepared in a state |0>. Next, the signal to be measured is injected into one end of the transmission line. After a certain period of time, the state of the qubits is measured. If any of the qubits, absorbent elements (2) are in state |g> we can assure that the waveguide (1) has transported at least one photon with a probability equal to or greater than the efficiency of the detector.

If the number of qubits found in state |g> is Ng, it can be affirmed that the signal transported at least Ng with a confidence proportional to efficiency $1 - (1 - \alpha)^{Ng}$.

Calculation of detector efficiency requires mathematical modelling of the problem, which can be performed by simply knowing the previously mentioned requirements. This modelling can be performed using a non-conservative Schrödinger equation.

Detection efficiency can be optimised for a device having a preset number of detection elements N. Maximum detection is obtained for resonant qubits (with $\delta = 0$ or $\omega = \omega_0$) in such a manner that for one or many qubits next to each other, detection efficiency is limited to 50%. When two separate qubits $\lambda/2$ are separated half a wavelength, an efficiency of 80% is obtained, which is arbitrarily increased as more detection elements are added.

## DESCRIPTION OF THE DRAWINGS

In order to complement the description being made and with the object of helping to better understand the characteristics of the invention, in accordance with a preferred example of practical embodiment thereof, a set of drawings has been included as an integral part of said description, wherein the following have been represented in an illustrative and non-limiting manner:

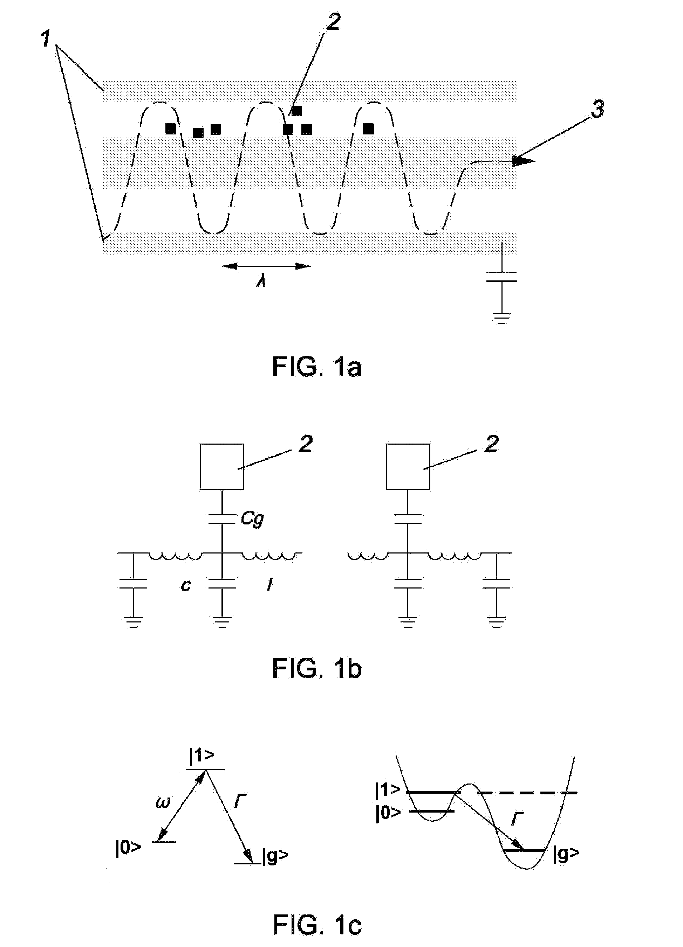

Figure 1.a.- Shows a schematic view of a coaxial, flat waveguide having a number of coplanar absorbent elements coupled thereto. Microwave radiation through the waveguide.
Figure 1.b.- Shows an equivalent quantum circuit.
Figure 1.c.- Shows how each qubit element has two metastable levels |0> and |1>. The absorbent element (2) or qubit can therefore absorb a photon and perform an irreversible transition $0 \rightarrow 1 \rightarrow g$.

## PREFERRED EMBODIMENT OF THE INVENTION.

In this section a model implementation of the design is explained using the currently available elements and circuits. A coplanar coaxial waveguide (1), with absorbent elements (2) acting as detectors in accordance with recent experiments, are used to transport the microwave radiation (3). It must be highlighted that, as opposed to these experiments, the waveguide (1) is not cut at the ends to form a resonator, but rather is left free so that the photons are freely propagated therethrough.

The waveguide (1) is characterised by two intensive quantities: inductance per unit of length, $l$, and capacitance per unit of length, c. Based on these two quantities, in accordance with the regular LC models, the dispersion relation $\omega_0 = v_g |k|$ is obtained, with a group speed independent of frequency of $v_g = \dfrac{1}{\sqrt{lc}}$.

So-called phase or "current-biased Josephson junction" qubits, i.e. a Josephson junction driven by a current $l$ with values very proximate to those of the critical current of junction $l_0$, are used as detection absorbent elements (2). This circuit element is characterised by two quantities. Firstly, the energy of Josephson $E_J = I_0\phi_0$, product of the critical current multiplied by the flow unit

$$\phi_0 = \frac{\hbar}{2e}$$ . Secondly, the loading energy $E_c = \frac{2e^2}{C_j}$,

a function of the capacitance of junction $C_j$.

Coupling between the absorbent element (2), i.e. the phase qubit, and the waveguide (1) can be carried out capacitively. In this case, the coupling constant V of the design is given by the formula:

$$V = \frac{C_g}{C_J + C_g} \frac{e}{\alpha} \sqrt{\frac{\hbar\omega_0}{c}}$$

Here, capacitance appears between the phase qubit and the transmission line, $C_g$, and a number

$$\alpha^2 = \frac{E_C}{\hbar\omega}$$ which depends on the loading energy and the difference in energy between the two metastable levels with less energy, |0> and |1>, of our phase qubit.

The adimensional parameter that determines the efficiency of the detector follows the formula:

$$\gamma = \frac{\alpha^2}{c_{12}^2} \frac{\hbar}{e^2 Z_0} \frac{\Gamma}{\omega_0}$$ , where $Z_0 = \sqrt{\frac{l}{c}}$ is the impedance of the transmission line and $C_{12} = \frac{C_g}{C_g + C_J}$ . In this formula, it is evident that there are sufficient free parameters, $Z_0, \Gamma, C_{12}, E_C, \omega_0$, to achieve approximation to the regime of maximum efficiency.

For example, for a single qubit or detection element, the parameters of the experiment conducted by Berkley et al can be used directly, where we obtain $C_J$ =4,8pF, $C_{12}$ = 0.13, $\alpha^2$= 0.02. Given that for a single qubit $\gamma \cong 1$ is required, by using realistic impedances $Z_0$ =10 -100Ω we obtain that qubit decline speed must be in the range of r =10 -100 MHz. Increasing the coupling between the guide and the qubit to $C_{12}$ = 0.26 represents increasing this speed to 30 - 300 MHz.

All of these values and requirements fall within the experimentally accessible ranges.

## Claims

1. Photon detector in the microwave range, **characterised in that** it comprises:

    • a waveguide (1) carrying microwave radiation, and
    • absorbent elements (2).

2. Photon detector in the microwave range, according to claim 1, wherein the radiation-carrying waveguide (1) is of the coaxial flat type, inserted between two earthed conducting planes.

3. Photon detector in the microwave range, according to claim 1, wherein the bistable absorbent elements (2) in charge of detection are much smaller in size than wavelength λ.

4. Photon detector in the microwave range, according to claim 1, wherein the flat waveguide (1) includes embedded absorbent elements (2) built from direct current-driven Josephson junctions.

5. Microwave photon detection method using the detection device described in claims 1 to 4, **characterised in that** detection of the microwave photons is carried out from the irreversible changes generated in the bistable absorbent elements (2) due to the passage of microwave radiation (3).

6. Microwave photon detection method, according to claim 5, **characterised in that** the irreversible change caused by the passage of microwave radiation (3) in the bistable absorbent (2) elements can be quantified upon completion of wave induction.

7. Bistable absorbent elements (2), **characterised** for their photon absorption capacity and which, in turn, act as photon detectors.

FIG. 1a

FIG. 1b

FIG. 1c

# INTERNATIONAL SEARCH REPORT

International application No.

PCT/ ES 2009/070428

**A. CLASSIFICATION OF SUBJECT MATTER**

see extra sheet

According to International Patent Classification (IPC) or to both national classification and IPC

**B. FIELDS SEARCHED**

Minimum documentation searched (classification system followed by classification symbols)

G01T 1, H01L 39/22, H01L 27/18, G06N 99

Documentation searched other than minimum documentation to the extent that such documents are included in the fields searched

Electronic data base consulted during the international search (name of data base and, where practicable, search terms used)

EPODOC, INSPEC, IEEE, EMBASE, COMPENDEX

**C. DOCUMENTS CONSIDERED TO BE   RELEVANT**

| Category* | Citation of document, with indication, where appropriate, of the relevant passages | Relevant to  claim No. |
|---|---|---|
| X | WALLRAFF et al.: "Strong coupling of a single photon to a superconducting qubit using circuit quantum electrodynamics" in NATURE, vol.431, pages 162-167 (Nature Publishing Group, UK) 09.09.2004 | 1-7 |
| A | METCALFE et al.: "Measuring the decoherence of a quantronium qubit with the cavity bifurcation amplifier" in Physical Review B, vol. 76, n°. 17, id. 174516 (American Physical Society, USA) 01.11.2007 | 1-7 |
| A | SHWETANK et al.: "Temperature dependence of the frequency and noise of superconducting coplanar waveguide resonators" in Applied Physics Letters, vol. 92, n° 12, pages 123503(1)-123503(3) (AIP, USA) 25.03.2008 | 1-7 |
| A | SIMMONDS: "Quantum information with superconducting quantum bits and cavities". Conference Lasers and Electro-Optics, 2008. CLEO 2008 in Piscataway, NJ, USA. 04.05.2008 | 1-7 |

☐ Further documents are listed in the continuation of Box C.          ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance. | | |
| "E" | earlier document but published on or after the international filing date | | |
| "L" | document which may throw doubts on priority claim(s) or which is cited to establish the publication date of another citation or other special reason (as specified) | "X" | document of particular relevance; the claimed invention cannot be considered novel or cannot be considered to involve an inventive step when the document is taken alone |
| "O" | document referring to an oral disclosure use, exhibition, or other means | "Y" | document of particular relevance; the claimed invention cannot be considered to involve an inventive step when the document is combined with one or more other documents , such combination being obvious to a person skilled in the art |
| "P" | document published prior to the international filing date but later than the priority date claimed | | |
| | | "&" | document member of the same patent family |

| Date of the actual completion of the international search | Date of mailing of the international search report |
|---|---|
| 28.January.2010       (28.01.2010) | **(05/02/2010)** |
| Name and mailing address of the ISA/ O.E.P.M. | Authorized officer |
| Paseo de la Castellana, 75 28071 Madrid, España. Facsimile No.   34 91 3495304 | J. Olalde Sánchez Telephone No. +34 91 349 84 69 |

Form PCT/ISA/210 (second sheet) (July 2009)

| INTERNATIONAL SEARCH REPORT | International application No.<br><br>PCT/ ES 2009/070428 |
| --- | --- |

CLASSIFICATION OF SUBJECT MATTER

*G01T 1/24* (2006.01)
*H01L 39/22* (2006.01)
*H01L 27/18* (2006.01)
*G06N 99/00* (2010.01)

Form PCT/ISA/210 (extra sheeet) (July 2009)

<div align="center">

## INFORME DE BÚSQUEDA INTERNACIONAL

</div>

| | |
|---|---|
| | Solicitud internacional Nº<br><br>PCT/ ES 2009/070428 |

**A. CLASIFICACIÓN DEL OBJETO DE LA SOLICITUD**

Ver hoja adicional

De acuerdo con la Clasificación Internacional de Patentes (CIP) o según la clasificación nacional y CIP.

**B. SECTORES COMPRENDIDOS POR LA BÚSQUEDA**

Documentación mínima buscada (sistema de clasificación seguido de los símbolos de clasificación)
G01T 1, H01L 39/22, H01L 27/18, G06N 99

Otra documentación consultada, además de la documentación mínima, en la medida en que tales documentos formen parte de los sectores comprendidos por la búsqueda

Bases de datos electrónicas consultadas durante la búsqueda internacional (nombre de la base de datos y, si es posible, términos de búsqueda utilizados)
EPODOC, INSPEC, IEEE, EMBASE, COMPENDEX

**C. DOCUMENTOS CONSIDERADOS RELEVANTES**

| Categoría* | Documentos citados, con indicación, si procede, de las partes relevantes | Relevante para las reivindicaciones Nº |
|---|---|---|
| X | WALLRAFF et al.: "Strong coupling of a single photon to a superconducting qubit using circuit quantum electrodynamics" en NATURE, vol.431, páginas 162-167 (Nature Publishing Group, UK) 09.09.2004 | 1-7 |
| A | METCALFE et al.: "Measuring the decoherence of a quantronium qubit with the cavity bifurcation amplifier" en Physical Review B, vol. 76, nº. 17, id. 174516 (American Physical Society, USA) 01.11.2007 | 1-7 |
| A | SHWETANK et al.: "Temperature dependence of the frequency and noise of superconducting coplanar waveguide resonators" en Applied Physics Letters, vol. 92, nº 12, páginas 123503(1)-123503(3) (AIP, USA) 25.03.2008 | 1-7 |
| A | SIMMONDS: "Quantum information with superconducting quantum bits and cavities". Conferencia Lasers and Electro-Optics, 2008. CLEO 2008 en Piscataway, NJ, USA. 04.05.2008 | 1-7 |

☐ En la continuación del Recuadro C se relacionan otros documentos    ☐ Los documentos de familias de patentes se indican en el Anexo

| * Categorías especiales de documentos citados: | "T" documento ulterior publicado con posterioridad a la fecha de presentación internacional o de prioridad que no pertenece al estado de la técnica pertinente pero que se cita por permitir la comprensión del principio o teoría que constituye la base de la invención. |
|---|---|
| "A" documento que define el estado general de la técnica no considerado como particularmente relevante. | |
| "E" solicitud de patente o patente anterior pero publicada en la fecha de presentación internacional o en fecha posterior. | |
| "L" documento que puede plantear dudas sobre una reivindicación de prioridad o que se cita para determinar la fecha de publicación de otra cita o por una razón especial (como la indicada). | "X" documento particularmente relevante; la invención reivindicada no puede considerarse nueva o que implique una actividad inventiva por referencia al documento aisladamente considerado. |
| "O" documento que se refiere a una divulgación oral, a una utilización, a una exposición o a cualquier otro medio. | "Y" documento particularmente relevante; la invención reivindicada no puede considerarse que implique una actividad inventiva cuando el documento se asocia a otro u otros documentos de la misma naturaleza, cuya combinación resulta evidente para un experto en la materia. |
| "P" documento publicado antes de la fecha de presentación internacional pero con posterioridad a la fecha de prioridad reivindicada. | "&" documento que forma parte de la misma familia de patentes. |

| Fecha en que se ha concluido efectivamente la búsqueda internacional.<br><br>28.Enero.2010      (28.01.2010) | Fecha de expedición del informe de búsqueda internacional<br><br>**05 de Febrero de 2010 (05/02/2010)** |
|---|---|
| Nombre y dirección postal de la Administración encargada de la búsqueda internacional      O.E.P.M.<br><br>Paseo de la Castellana, 75 28071 Madrid, España.<br>Nº de fax 34 91 3495304 | Funcionario autorizado<br><br>J. Olalde Sánchez<br><br>Nº de teléfono +34 91 349 84 69 |

Formulario PCT/ISA/210 (segunda hoja) (Julio 2009)

**INFORME DE BÚSQUEDA INTERNACIONAL**

Solicitud internacional Nº

PCT/ ES 2009/070428

CLASIFICACIÓN DEL OBJETO DE LA SOLICITUD

*G01T 1/24* (2006.01)
*H01L 39/22* (2006.01)
*H01L 27/18* (2006.01)
*G06N 99/00* (2010.01)